# EUROPEAN PATENT SPECIFICATION

(11) **EP 4 203 019 B1**
(45) Date of publication and mention of the grant of the patent: **08.07.2026**
(21) Application number: 21217512.9
(22) Date of filing: 23.12.2021
(51) Int. Cl.: H10W 72/50, H10W 90/10, H10W 90/00, H10W 72/00, H10W 72/90

(54) **POWER MODULE AND METHOD FOR MANUFACTURING A POWER MODULE**
LEISTUNGSMODUL UND VERFAHREN ZUR HERSTELLUNG DES LEISTUNGSMODULS
MODULE DE PUISSANCE ET PROCÉDÉ DE FABRICATION D'UN MODULE DE PUISSANCE

(43) Date of publication of application: 28.06.2023
(73) Proprietor: Hitachi Energy Ltd, 8050 Zürich (CH)
(72) Inventor: FISCHER, Fabian, 5400 Baden (CH); MALEKI, Milad, 5417 Untersiggenthal (CH); BEYER, Harald, 5600 Lenzburg (CH)
(74) Representative: Epping - Hermann - Fischer

(56) References cited:
- EP-A2- 2 645 414
- WO-A1-2021/033565
- US-B2- 11 018 109

## Description

The present disclosure relates to a power module and a method for manufacturing a power module. The power module can be used in power electronic applications, such as motor drives or power converters in electric vehicles (EV), for example. The power module can be a power semiconductor module. The power module may be a high voltage power module.

The power modules may comprise silicon, silicon carbide, gallium nitride or other semiconductor devices, for example. The power module may comprise wide-bandgap devices such as silicon carbide and gallium nitride devices. The semiconductor device may be a switching devices, such as an insulated gate bipolar transistors (IGBT) or power MOSFET or MISFET transistor, for example.

Documents JP 2016-46279 A, US 4,692,789, JP 2008263675 A, DE 10 2010 000 951 A1, US 11 018 109 B2, EP 2 645 414 A2 and WO 2021/033565 A1 disclose power semiconductor modules.

Embodiments of the disclosure relate to a power module having an improved electromagnetic behavior.

According to a first aspect of the disclosure, a power module comprises at least one substrate, at least one switching device located on the substrate, at least one power path for supplying power to the switching device and at least one auxiliary path for controlling and/or monitoring the switching device, wherein the auxiliary path comprises at least one connection portion comprising two or more connectors electrically connected in parallel. A power path may be also a path for supplying power from the switching device to the outside.

The power module may comprise power terminals such as positive DC ("DC+") and negative DC ("DC-") terminals. For specific modules, also an output (AC) terminal may be present. The power path carries current between the switching devices and the power terminals.

Furthermore, the power module may comprise auxiliary terminals connected to the one or more auxiliary paths for monitoring and controlling the device. The device may be controlled from outside or by internal control devices. Such internal control devices may be present in intelligent power modules, for example.

As examples, an auxiliary path may be a signal path, such as for connection to a gate of the switching device, or may be a connection between emitter, collector, source and/or drain with an associated auxiliary terminal. The current flowing through the auxiliary terminals and in the auxiliary paths is much lower than the current in the power path. As an example, a current in the auxiliary paths may be below 1 Ampere. The current flowing through the power terminals may be several hundred Ampere, for example.

The switching device may be in the form of an IGBT, a MOSFETS or MISFETS, for example. The power module may comprise a first switching device and a second switching device electrically connected to form a half bridge, for example.

The connectors may be in the form of wire bonds, ribbons and/or clips, for example. It is also possible that different forms are combined in one connection portion. The connectors may be directly connected to a metal pattern and/or to a contact of the switching device and/or may be connected on top of each other. As an example, the connectors may be in the form of stacked bond wires or ribbons, wherein only the lowermost connector may be directly connected to the metal pattern or the switching device. Furthermore, it is also possible that one or more of the connectors is in the form of a section of a metal pattern. The section may be a narrow metal path. As an example, a wire bond, ribbon or clip may be connected in parallel to a section of a metal pattern.

The connection portion may comprise at least two connectors electrically connected in parallel. The connection portion may comprise at least three connectors electrically connected in parallel. As examples, the connection portion may comprise four or ten connectors connected in parallel.

In common power module designs, only one single wire bond is used for the interconnection of metal patterns and/or contacts in auxiliary paths while several wire bonds may be used for the interconnection of metal patterns in power paths. In an auxiliary path, a single wire for the interconnection is generally sufficient, because, in contrast to the power path, only a low current is applied to the auxiliary path. However, the comparable small cross-sectional area of a single bond wire may enhance parasitic inductances which lead to oscillations, e.g. of the gate signals, and switching losses which may be particularly relevant for fast switching.

Furthermore, the parasitic inductances cause oscillations in gate signals, for example, and thereby present a limiting factor for the switching frequency. Because high switching frequencies are available in applications using power modules based on silicon carbide (SiC) such as SiC power MOSFETSs, for example, a single bond wire can be a limiting factor in these applications. With an increased number of parallel connectors, the available switching frequency can be better utilized or enhanced due to a reduced parasitic inductance.

Generally, by providing parallel connectors in the auxiliary path, at least one electromagnetic characteristic of the switching device may be adjusted or configured to improve electromagnetic behavior. The electromagnetic characteristic may be at least one of parasitic inductance, self-inductance of the auxiliary path, and homogeneous switching behavior of the at least one switching device with respect to another switching device in the power module. The number of parallel connectors in the connection portion may be chosen such that the characteristic may be adjusted by a pre-defined value. As an example, the pre-defined value may be a relative or absolute difference to the value of the characteristic for a connection portion with only a single connector.

The connection portion may be configurable such that the connection portion enables attaching a certain number of connectors in parallel. As an example, the metallization or a pad to which the parallel connectors are fixed may provide enough space for attaching at least two connectors electrically in parallel and located besides each other along a main surface of the substrate. As an example, enough space may be provided for ten parallel connectors located besides each other. It is also possible that at least some of the parallel connectors are located above each other and some of the parallel connectors are located besides each other. As an example, the number of parallel connectors in the connection portion may be such that a parasitic inductance of the auxiliary path, such as the gate inductance, for example, is reduced by at least 5 % compared to an inductance of the auxiliary path with only a single connector in the connection portion. The inductance may be reduced by at least 10 %, for example. As an example, four parallel connectors may be provided.

The power module may comprise at least two auxiliary paths, each comprising at least one connection portion with several connecters connected in parallel. The number of connectors is different in the connection portions. As an example, the number of connectors may be selected such that the inductances of the auxiliary paths are adjusted to each other or adjusted according to the required individual reduction of the parasitic inductance of an auxiliary path.

The power module comprises several switching devices. The switching devices have corresponding auxiliary paths. As an example, each of the switching devices may have an auxiliary path leading to a gate contact. As a further example, each of the switching devices may have one or more auxiliary paths connecting source, drain, emitter and/or collector to an auxiliary terminal. The auxiliary paths with the same functionality are referred to as "corresponding" auxiliary paths. As an example, the gate switching paths are corresponding auxiliary paths. Also the auxiliary source paths are corresponding auxiliary paths.

The number of the parallel connectors may , in accordance with an embodiment of the claimed invention, be different for corresponding auxiliary paths for different switching devices. As an example, for one of the switching devices the number of parallel connectors in a gate auxiliary path may be higher than for the other switching device. It is also possible that , in accordance with an alternative embodiment of the invention, one of the switching devices comprises parallel connectors in an auxiliary path, wherein the other one of the switching devices does not comprise parallel connectors in a corresponding auxiliary path, i.e., only comprises single connectors.

The number of parallel connectors in the auxiliary paths may be chosen such that a homogenization in the characteristics of the auxiliary paths is achieved, e.g., in the parasitic inductance. As an example, a homogenization may be such that the parasitic inductances in the different auxiliary paths differ not more than 10 % from an average value of the parasitic inductances in these auxiliary paths.

The power module may comprise a high side switching device and a low side switching device forming a half-bridge. The connection portion comprising the parallel connectors may be present in an auxiliary path connected to a gate of the low side switching device, for example. For the high side switching device, only single wire bonds may be present in the auxiliary paths or the number of wire bonds in connections may be less than for the low side switching device. Alternatively, depending on the differences in the initial parasitic inductance with only one connector, the number of wire bonds in connections may be the same or higher for the high side device than for the low side device.

The power module may comprise a switching device comprising several auxiliary paths. As an example, the auxiliary paths may be two or more of auxiliary paths connected to gate, source, drain, emitter or collector of the switching device. At least two of the auxiliary paths may comprise a connection portion with parallel connectors, wherein the number of the parallel connectors is different for the auxiliary paths. It is also possible that one of the auxiliary paths comprises a connection portion with parallel connectors and another one of the auxiliary paths does not comprise a connection portion with parallel connectors. As an example, a gate path may comprise several parallel connectors and a source auxiliary path may comprise only single connectors. The number of connecters may be chosen individually to obtain an optimized balance for inductances and costs, for example.

According to a further aspect of the disclosure, a method for manufacturing the power module comprises the step of specifying an electromagnetic characteristic and defining a value by which the electromagnetic characteristic is to be changed. The method comprises the further step of providing a power module comprising at least one substrate, at least one switching device located on the substrate, at least one power path for supplying power to or from the at least one switching device and at least one auxiliary path for controlling and/or monitoring the switching device, wherein the at least one auxiliary path comprises at least one connection portion that comprises two or more connectors electrically connected in parallel, wherein the number of connectors is chosen such that the electromagnetic characteristic is changed by the defined value or adjusted to the desired value.

The needed number of connectors may be determined by simulations or measurements on samples in the product development, for example. As an example, an initial power module may be provided and a value for the electromagnetic characteristic of the initial power module may be determined. The initial power module may comprise at least one substrate, at least one switching device located on the substrate, at least one power path for supplying power to the at least one switching device and at least one auxiliary path for controlling and/or monitoring the switching device. The auxiliary path comprises a connection portion with a single connector or several parallel connectors. A value for adjusting the electromagnetic characteristic may be defined. The number of parallel connectors in the connection portion may be adjusted, and thus configured to achieve the desired adjustment of the electromagnetic characteristic. As an example, the number of parallel connectors may be increased as compared to the initial power module.

The resulting power module may have any functional and/or structural characteristics of the power module disclosed in the foregoing.

The electromagnetic characteristic of a power module may be described by at least one of stray inductance, mutual coupling commutation, and by the gate inductance, which describes the self-inductance of the one or more gate paths. The electromagnetic characteristic, especially the gate inductance, is responsible for the generation of oscillations and consequently for the switching frequency and for homogeneous switching behavior of the at least one switching device with respect to another switching device in the power module. The defined value of the characteristic may be an amount of reducing or increasing the value of the electromagnetic characteristic. As an example, the amount may be a percentage or an absolute value.

As an example, the electromagnetic characteristic may be the gate inductances for the auxiliary paths in the initial power module and one or more auxiliary paths are identified in which a reduction of the inductance value is required. After that, one or more connecters are added in these auxiliary paths.

The number of connectors in the connection portion may be selected such that an inductance of the auxiliary path is set near or below a pre-defined value. As an example, the inductance of the auxiliary path, e.g. of the gate path, may be reduced by at least 5 % or at least 10 % compared to an inductance of the auxiliary path with only a single connector in the connection portion.

The power module comprises several switching devices comprising corresponding auxiliary paths such as gate auxiliary paths. The switching devices may be electrically connected in parallel. The number of parallel connectors are chosen such that the inductance in each of the corresponding auxiliary paths differs at most 10 % from an average value of the inductances in the corresponding auxiliary paths. As an example, the number of parallel connectors in one of the auxiliary paths may be selected and the number of parallel connectors in the other auxiliary paths are then selected such that the inductances are as close as possible to the inductance in the first auxiliary path. Thereby, a homogenous switching behavior can be achieved.

Further features, refinements and expediencies become apparent from the following description of the exemplary embodiments in connection with the figures. In the figures, elements of the same structure and/or functionality may be referenced by the same reference signs. It is to be understood that the embodiments shown in the figures are illustrative representations and are not necessarily drawn to scale.

The invention is as defined in the appended claims.
Figure 1 is a top view of a power module according to an example not in accordance with the claims,
Figure 2 is a perspective view of a detail of the power module of Figure 1,
Figure 3 is a top view of a power module according to an embodiment of the invention.

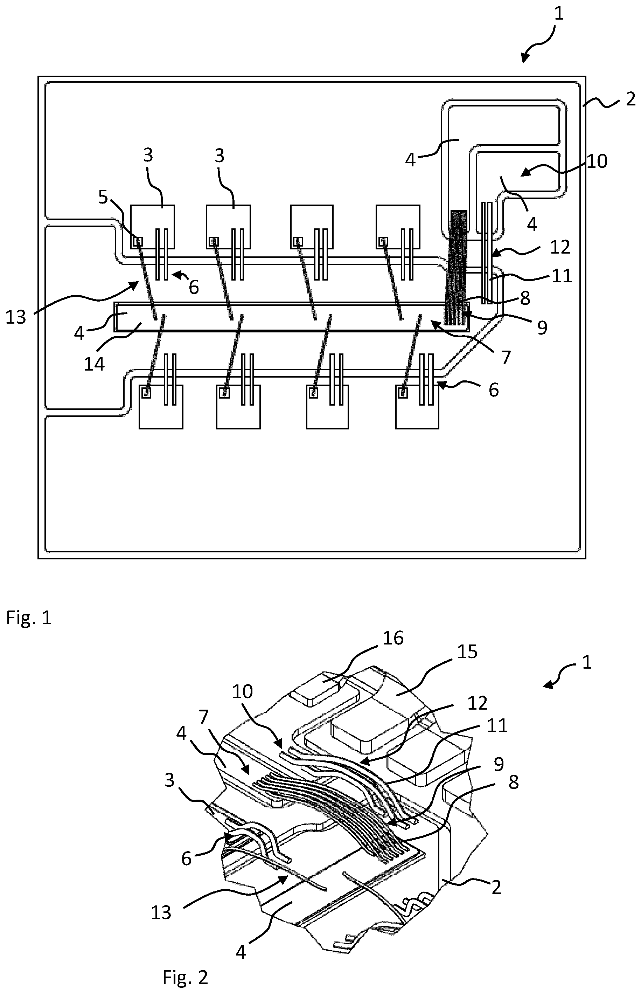

Figure 1 shows a top view of an example of a power module 1. The power module 1 is a semiconductor module comprising an isolating substrate 2 on which switching devices 3 in the form of power semiconductor devices are mounted. The power module 1 may be in the form of a half-bridge power module and may be used in automotive applications, for example. The power module 1 may comprise low side and high side switch devices which may be arranged in the form of rows on the substrate 2, for example. The switching devices 3 may be SiC power MOSFETs, for example. For illustrating purposes, figure 1 only shows the low side devices and simplified metallization pattern.

On the substrate, several metal patterns 4 for electrical connections of parts of the power module 1 are provided. On the one hand, electrical connections are required for power paths 6, electrically interconnecting collector and emitter (e.g. IGBT) or drain and source contacts (e.g. MOSFET) of the devices 3. The power path 6 is connected from the outside by a power terminal 15. On the other hand, electrical connections are required for auxiliary paths 7, 10 which may be used for monitoring or control purposes. As an example, auxiliary paths 7 may be provided for electrically connecting a gate, wherein auxiliary path 10 may be provided for connecting a source to an auxiliary terminal.

Depending on the substrate layout, the electrical path of the auxiliary circuit, i.e., the auxiliary path 7, 10 may be provided by two or more separate metal patterns 4 of the substrate 2. The metal patterns 4 can be interconnected by connectors 8, 11 in the form of wire bonds, ribbons or other connecters such as clips, for example. It is also possible than one of the connectors is formed as a narrow metal pattern. Also interconnections between metal patterns 4 and contacts 5 on the devices 3 can be provided by such connectors 8, 11. As an example, a gate contact pad on a chip may be connected to a metal pattern 4 by a wire bond connection.

As can be seen in a detailed view of an embodiment shown in Figure 2, a first auxiliary path 7 comprises a connection portion 9 between two separate metal patterns 4, the connection portion 9 being formed by more than two connectors 8. In the shown embodiment, the first auxiliary path 7 is an electrical path for a gate. The first auxiliary path 7 is connected from the outside by an auxiliary terminal. The separate metal patterns 4 may be separated by a source pattern of the power circuit, for example. One of the metal patterns 4 is a gate metal pattern 14 connected to gate contacts 5 of the switching devices 3. The connectors 8 in the connection portion 9 are in the form of wire bonds. The connectors 8 are electrically connected in parallel to each other. In the shown embodiment, the connection portion 9 is formed by ten connectors 8 in the form of wire bonds. The connectors 8 are arranged at two levels above each other. Five connectors 8 are arranged at a first level and further five connectors 8 are arranged above the first connectors 8 at a second level. This arrangement helps to safe space.

Also a second auxiliary path 10 comprises a connection portion 12 between two separate metal patterns 4, the connection portion 12 being formed by several connectors 11 being connected in parallel to each other. The second auxiliary path is connected from the outside by an auxiliary terminal 16. The second auxiliary path 10 is an electrical path for auxiliary source connections. Here, the connection portion 12 is formed by four connectors 11 in the form of wire bonds, wherein the wire bonds are arranged at two levels above each other. Each level comprises two wire bonds.

In the shown embodiment, the connection portions 9, 12 in the different auxiliary paths 7, 10 comprise different numbers of connectors 8, 11. It is also possible that the connection portions 9, 12 comprise the same number of connectors 8, 11. The number of connectors 8, 11 may depend on the need of reduction of parasitic inductances below a certain value for each path.

In different embodiments, the connectors 8, 11 may have the form of ribbons, for example. The material of the connectors 8, 11 may be copper, aluminum, gold, silver or corresponding alloys, for example. Bond wire diameters may be between 50 µm and 500 µm, for example.

While parallel connectors in power paths 6 are often used for increasing the current carrying capacitance, parallel connectors are not required for this purpose in auxiliary paths 7, 10 because of the low current in the auxiliary paths.

However, it has been found that by providing several parallel connectors in connections in an auxiliary path 7, 10, the electromagnetic behavior can be improved, allowing faster switching and reduced losses. As an example, parasitic inductances in the auxiliary paths 7, 10 can be reduced, resulting in lower oscillations during switching and reduced switching losses.

As an example, the number of connectors 8, 11 in a connection portion 9, 12 may be selected such that the parasitic inductance is reduced by at least 10 % compared to the inductance with only a single connector in a connection portion.

In the embodiment shown in Figures 1 and 2, another connection portion 13 in an auxiliary path between a contact 5 in the form of a gate pad on the device 3 and the gate metal pattern 14 is formed by a single connector in the form of a bond wire.

Furthermore, the connection portions comprising several parallel connectors can be connections of metal patterns 4 and/or chip contacts 5 located on the same insulating substrate 2. It is also possible that the connection portions interconnect metal patterns 4 and/or chip contacts 5 located on different insulating substrates.

The power module 1 may comprise first and second switches connected to form a half-bridge. A half-bridge is an electric circuit comprising two switches connected in series between a DC+ and DC- terminal, wherein an AC terminal is connected to emitter or source of the high side switch and to the collector or drain of the low side switch. The switch connected to the DC+ terminal is denoted as high side (HS) switch, the switch connected to the DC- terminal is denoted as low side (LS) switch.

It is possible to provide the connection portions 9, 12 with multiple parallel connectors 8, 11 only for auxiliary paths 7, 10 such as a gate signal path of the low side device and not provide such a connection with multiple parallel connectors for the high side device. It is also possible to provide connection portions 9, 12 with multiple parallel connectors 8, 11 for auxiliary paths 7, 10 for both the low side and the high side device. In this case, the number of connectors can be the same for both sides. It is also possible to provide more connectors in the connection portion for the high side device than for the low side device.

As an example, an auxiliary path for the low side device may have a connection with 10 parallel bond wires and an auxiliary path for the high side device may have a connection with only 2 parallel bond wires. The 10 parallel bond wires may be provided to decrease the inductance.

The number of parallel connectors for each path may be determined individually according to the maximum allowed value of inductance, and for homogenization. As an example, this may lead to that the number of bond wires for gate of high side may be higher than the number of bond wires in an auxiliary path connecting source, drain, emitter or collector to an auxiliary terminal. As an example, several parallel connectors may be provided for a gate path but only one connector may be provided in an auxiliary source or drain path.

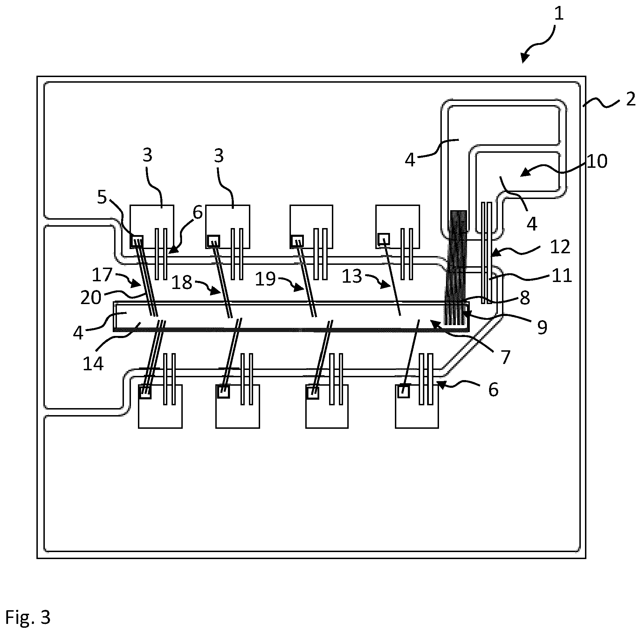

Figure 3 shows an embodiment of a power module 1 in accordance with the invention in a schematic view from the top. Compared to the power module 1 shown in Figure 1, at least some of the auxiliary paths connected to the contacts 5 on the switching devices 3 comprise a connection portion 17, 18, 19 with parallel connectors 20. The contact 5 may be a gate contact. Here, the number of connectors 20 in the connection portions 17, 18, 19 are , in accordance with the invention, different for at least two switching devices 3 to achieve a homogenization of the individual inductances. In one auxiliary path from a contact 5 to the metal pattern 4, no parallel connection portion is provided, but only another connection portion 13 comprising a single connector. Generally, the connection portions 17, 18, 19, 9, 12 are configurable such that enough space is provided to attach several connectors 20, 8, 11 electrically and mechanically in parallel to each other. In the shown embodiment, both the gate metal pattern 14 and each of the gate contacts 5 provide enough space for attaching at least three connectors 20 in parallel.

Simulations have shown the effect of providing a plurality of parallel bond wires in a gate signal path for a low side power device with the gate signal path of the high side portion remaining unchanged. The number of bond wires was changed in the same auxiliary path.

The electromagnetic behavior of both module designs was calculated by finite element simulations. Several characteristics describing the electromagnetic behavior were analyzed. The gate inductance describes the self-inductance of the gate path itself having impact on the increase or decrease of the voltage applied to the gate and consequently on the generation of oscillations limiting the switching frequency. Here the change of current in the gate path with respect to time is relevant for the magnitude of the induced voltage and the generated oscillations. The mutual coupling commutation describes the induction of a magnetic field and consequently of a voltage in a gate loop, which is provided by changes of the electric current from DC+ to DC+ or vice versa in the commutation loop with respect to time. Here, on one hand, the mean value describes the impact of the coupling inductance in general, resulting in faster (positive inductance) or slower (negative inductance) switching of all device. On the other hand, the difference between highest and lowest value of the single coupling inductances of all devices is an important parameter for the homogeneity of the switching velocity of the individual devices with respect to each other, because a difference results in different inducted voltages. Here, a small difference is related to a good homogeneity in the switching behavior.

The calculations show on one hand a negligible impact of the introduction of multiple parallel bond wires on the stray inductance which is the self-inductance of the power path and also on the coupling inductance. The calculations show on the other hand a significant reduction of the gate inductance being responsible for the generation of oscillations during switching. The following values of the gate inductance of the low side devices were calculated:
▪ 1 bond wire: 24.82 nH
▪ 4 bond wires: 21.50 nH
▪ 10 bond wires: 21.01 nH

These results show that an increasing number of parallel bond wires results in a decreasing gate inductance of the low side devices. The gate inductance can be reduced by 13.4 % by using 4 bond wires and can be further reduced by increasing the number of bond wires. The gate inductance may be reduced by up to 15 %.

The connections with multiple parallel connectors can be also used for the interconnection between metal patterns of the substrate and gate pads of the chips for a corresponding or additional reduction of the gate inductance.

It is also possible to provide a different number of parallel connectors for each power semiconductor device for improving homogenization of the switching behavior. Specifically, the number of parallel connectors in the auxiliary path from a gate contact to a metallization may be different, as shown in Figure 3. As an example, the number of connectors in a gate signal path may be selected such that the gate inductance of each of the devices is as near as possible to a specific value for each of the switching devices.

Additionally, multiple parallel connectors such as bond wires may be introduced to other electrical paths of the auxiliary circuit like auxiliary emitter /source or auxiliary collector / drain connections.

### Reference Signs

- 1: power module
- 2: substrate
- 3: switching device
- 4: metal pattern
- 5: contact
- 6: power path
- 7: auxiliary path
- 8: connector
- 9: connection portion
- 10: auxiliary path
- 11: connector
- 12: connection portion
- 13: other connection
- 14: gate metal pattern
- 15: power terminal
- 16: auxiliary terminal
- 17: connection portion
- 18: connection portion
- 19: connection portion
- 20: connector

## Claims

1. A power module (1)
comprising at least one substrate (2), at least one switching device (3) located on the substrate (2), at least one power path (6) for enabling current flow for supplying power to the at least one switching device (3) and at least one auxiliary path (7, 10) for enabling current flow for controlling and/or monitoring the switching device (3), wherein the at least one auxiliary path (7, 10) comprises at least one connection portion (9, 12, 17, 18, 19) that comprises two or more connectors (8, 11, 20) electrically connected in parallel,
wherein the power module (1) comprises several switching devices (3) having corresponding auxiliary paths (7, 10), **characterised in that**
at least two of the corresponding auxiliary paths (7, 10) comprise a corresponding connection portion (17, 18, 19) with parallel connectors (20), wherein the numbers of the parallel connectors (20) of the corresponding connection portions of the at least two of the corresponding auxiliary paths are different
or **in that**
one of the corresponding auxiliary paths comprises a connection portion (17, 18, 19) with parallel connectors (20) and another one of the corresponding auxiliary paths comprises a corresponding connection portion (13) with a single connector.

2. The power module of claim 1,
wherein the at least one connection portion (9, 12, 17, 18, 19) with connectors (8, 11, 20) electrically connected in parallel comprises at least three connectors (8, 11, 20) electrically connected in parallel.

3. The power module of any of the preceding claims,
wherein at least one of the connectors (8, 11, 20) is in the form of a wire bond, a ribbon or a clip.

4. The power module of any of the preceding claims,
wherein the switching device (3) comprises a gate for controlling switching, wherein the auxiliary path (7) is an electrical connection to the gate.

5. The power module of any of the preceding claims,
wherein the switching device (3) comprises an auxiliary terminal (16) for monitoring the switching device (3), wherein the auxiliary path (10) connects the auxiliary terminal (16) to emitter, collector, source or drain of the switching device (3).

6. The power module of any of the preceding claims,
wherein the corresponding auxiliary paths (7, 10) have the same functionality, wherein the functionality is a connection to a gate, a source, a drain, an emitter or a collector of the switching devices (3).

7. The power module of any of the preceding claims,
wherein the connectors (8, 11, 20) of the corresponding auxiliary paths (7, 10) are connected between a contact of the respective switching device (3) and a metal pattern (4, 14).

8. The power module of any of claims 1 to 6,
wherein the connection portion (9, 12, 17, 18, 19) interconnects separate metal patterns (4), wherein the separate metal patterns (4) are located on the same substrate (2) or on different substrates (2).

9. The power module of any of the preceding claims, comprising a low side switching device and a high side switching device forming a half-bridge, wherein the connection portion (9, 12, 17, 18, 19) is provided in corresponding auxiliary paths (7, 10) of the high side switching device and the low side switching device.

10. The power module of any of the preceding claims,
wherein at least one of the switching devices (3) comprises several auxiliary paths (7, 10), wherein at least two of the auxiliary paths (7, 10) comprise a connection portion (9, 12, 17, 18, 19) with connectors (8, 11, 20) electrically connected in parallel, wherein the number of the connectors (8, 11, 20) electrically connected in parallel is different in the auxiliary paths (7, 10), or wherein one of the auxiliary paths (7, 10) comprises a connection portion (9, 12, 17, 18, 19) with connectors (8, 11, 20) electrically connected in parallel and another one of the auxiliary paths (7, 10) does not comprise a connection portion (9, 12, 17, 18, 19) with connectors (8, 11, 20) electrically connected in parallel.

11. A method for manufacturing the power module (1) of claim 4, wherein the number of connectors (8, 11, 20) in each of the connection portions (9, 12, 17, 18, 19) is chosen such that gate inductances of the corresponding auxiliary paths (7, 10) are adjusted to differ at most 10 % from an average value of the inductances of the corresponding auxiliary paths (7, 10), wherein when in one of the auxiliary paths (7, 10) a reduction of the inductance value is required, the number of connectors (8, 11, 20) electrically connected in parallel in this auxiliary path (7, 10) is increased.

## Patentansprüche

1. Leistungsmodul (1),
umfassend mindestens ein Substrat (2), mindestens eine auf dem Substrat (2) angeordnete Schaltvorrichtung (3), mindestens einen Leistungspfad (6) zum Ermöglichen eines Stromflusses zur Leistungsversorgung der mindestens einen Schaltvorrichtung (3) und mindestens einen Hilfspfad (7, 10) zum Ermöglichen eines Stromflusses zum Steuern und/oder Überwachen der Schaltvorrichtung (3),
wobei der mindestens eine Hilfspfad (7, 10) mindestens einen Verbindungsabschnitt (9, 12, 17, 18, 19) umfasst, der zwei oder mehr parallel elektrisch verbundene Verbinder (8, 11, 20) umfasst,
wobei das Leistungsmodul (1) mehrere Schaltvorrichtungen (3) mit entsprechenden Hilfspfaden (7, 10) umfasst, **dadurch gekennzeichnet, dass**
mindestens zwei der entsprechenden Hilfspfade (7, 10) einen entsprechenden Verbindungsabschnitt (17, 18, 19) mit parallelen Verbindern (20) umfassen, wobei die Anzahl der parallelen Verbinder (20) der entsprechenden Verbindungsabschnitte der mindestens zwei der entsprechenden Hilfspfade unterschiedlich ist
oder dass
einer der entsprechenden Hilfspfade einen Verbindungsabschnitt (17, 18, 19) mit parallelen Verbindern (20) umfasst und ein anderer der entsprechenden Hilfspfade einen entsprechenden Verbindungsabschnitt (13) mit einem einzelnen Verbinder umfasst.

2. Leistungsmodul nach Anspruch 1,
wobei der mindestens eine Verbindungsabschnitt (9, 12, 17, 18, 19) mit parallel elektrisch verbundenen Verbindern (8, 11, 20) mindestens drei parallel elektrisch verbundene Verbinder (8, 11, 20) umfasst.

3. Leistungsmodul nach einem der vorhergehenden Ansprüche,
wobei mindestens einer der Verbinder (8, 11, 20) als Bonddraht, Band oder Clip ausgebildet ist.

4. Leistungsmodul nach einem der vorhergehenden Ansprüche,
wobei die Schaltvorrichtung (3) ein Gate zum Steuern des Schaltens umfasst, wobei der Hilfspfad (7) eine elektrische Verbindung zu dem Gate ist.

5. Leistungsmodul nach einem der vorhergehenden Ansprüche,
wobei die Schaltvorrichtung (3) einen Hilfsanschluss (16) zum Überwachen der Schaltvorrichtung (3) umfasst, wobei der Hilfspfad (10) den Hilfsanschluss (16) mit Emitter, Kollektor, Source oder Drain der Schaltvorrichtung (3) verbindet.

6. Leistungsmodul nach einem der vorhergehenden Ansprüche,
wobei die entsprechenden Hilfspfade (7, 10) dieselbe Funktionalität aufweisen, wobei die Funktionalität eine Verbindung zu einem Gate, einer Source, einem Drain, einem Emitter oder einem Kollektor der Schaltvorrichtungen (3) ist.

7. Leistungsmodul nach einem der vorhergehenden Ansprüche,
wobei die Verbinder (8, 11, 20) der entsprechenden Hilfspfade (7, 10) zwischen einem Kontakt der jeweiligen Schaltvorrichtung (3) und einem Metallmuster (4, 14) verbunden sind.

8. Leistungsmodul nach einem der Ansprüche 1 bis 6,
wobei der Verbindungsabschnitt (9, 12, 17, 18, 19) separate Metallmuster (4) miteinander verbindet, wobei die separaten Metallmuster (4) auf demselben Substrat (2) oder auf unterschiedlichen Substraten (2) angeordnet sind.

9. Leistungsmodul nach einem der vorhergehenden Ansprüche,
umfassend eine Low-Side-Schaltvorrichtung und eine High-Side-Schaltvorrichtung, die eine Halbbrücke bilden, wobei der Verbindungsabschnitt (9, 12, 17, 18, 19) in entsprechenden Hilfspfaden (7, 10) der High-Side-Schaltvorrichtung und der Low-Side-Schaltvorrichtung vorgesehen ist.

10. Leistungsmodul nach einem der vorhergehenden Ansprüche,
wobei mindestens eine der Schaltvorrichtungen (3) mehrere Hilfspfade (7, 10) umfasst, wobei mindestens zwei der Hilfspfade (7, 10) einen Verbindungsabschnitt (9, 12, 17, 18, 19) mit parallel elektrisch verbundenen Verbindern (8, 11, 20) umfassen, wobei die Anzahl der parallel elektrisch verbundenen Verbinder (8, 11, 20) in den Hilfspfaden (7, 10) unterschiedlich ist, oder wobei einer der Hilfspfade (7, 10) einen Verbindungsabschnitt (9, 12, 17, 18, 19) mit parallel elektrisch verbundenen Verbindern (8, 11, 20) umfasst und ein anderer der Hilfspfade (7, 10) keinen Verbindungsabschnitt (9, 12, 17, 18, 19) mit parallel elektrisch verbundenen Verbindern (8, 11, 20) umfasst.

11. Verfahren zum Herstellen des Leistungsmoduls (1) nach Anspruch 4,
wobei die Anzahl der Verbinder (8, 11, 20) in jedem der Verbindungsabschnitte (9, 12, 17, 18, 19) so gewählt wird, dass Gate-Induktivitäten der entsprechenden Hilfspfade (7, 10) so eingestellt werden, dass sie höchstens um 10 % von einem Durchschnittswert der Induktivitäten der entsprechenden Hilfspfade (7, 10) abweichen, wobei, wenn in einem der Hilfspfade (7, 10) eine Verringerung des Induktivitätswerts erforderlich ist, die Anzahl der in diesem Hilfspfad (7, 10) parallel elektrisch verbundenen Verbinder (8, 11, 20) erhöht wird.

## Revendications

1. Module de puissance (1)
comprenant au moins un substrat (2), au moins un dispositif de commutation (3) situé sur le substrat (2), au moins un chemin de puissance (6) pour permettre une circulation de courant afin d'alimenter en puissance au moins un dispositif de commutation (3) et au moins un chemin auxiliaire (7, 10) pour permettre une circulation de courant afin de commander et/ou contrôler le dispositif de commutation (3),
dans lequel l'au moins un chemin auxiliaire (7, 10) comprend au moins une portion de connexion (9, 12, 17, 18, 19) qui comprend deux connecteurs ou plus (8, 11, 20) électriquement connectés en parallèle,
dans lequel le module de puissance (1) comprend plusieurs dispositifs de commutation (3) ayant des chemins auxiliaires (7, 10) correspondants, **caractérisé en ce que** au moins deux des chemins auxiliaires (7, 10) correspondants comprennent une portion de connexion (17, 18, 19) correspondante avec des connecteurs parallèles (20), dans lequel les nombres des connecteurs parallèles (20) des portions de connexion correspondantes des au moins deux des chemins auxiliaires correspondants sont différents
ou **en ce que**
un des chemins auxiliaires correspondants comprend une portion de connexion (17, 18, 19) avec des connecteurs parallèles (20) et un autre des chemins auxiliaires correspondants comprend une portion de connexion (13) correspondante avec un connecteur unique.

2. Module de puissance selon la revendication 1,
dans lequel l'au moins une portion de connexion (9, 12, 17, 18, 19) avec des connecteurs (8, 11, 20) électriquement connectés en parallèle comprend au moins trois connecteurs (8, 11, 20) électriquement connectés en parallèle.

3. Module de puissance selon l'une quelconque des revendications précédentes,
dans lequel au moins un des connecteurs (8, 11, 20) est sous la forme d'une soudure de fils, d'un ruban ou d'une pince.

4. Module de puissance selon l'une quelconque des revendications précédentes,
dans lequel le dispositif de commutation (3) comprend une grille pour commander la commutation, dans lequel le chemin auxiliaire (7) est une connexion électrique à la grille.

5. Module de puissance selon l'une quelconque des revendications précédentes,
dans lequel le dispositif de commutation (3) comprend une borne auxiliaire (16) pour contrôler le dispositif de commutation (3), dans lequel le chemin auxiliaire (10) connecte la borne auxiliaire (16) à un émetteur, un collecteur, une source ou un drain du dispositif de commutation (3).

6. Module de puissance selon l'une quelconque des revendications précédentes,
dans lequel les chemins auxiliaires (7, 10) correspondants ont la même fonctionnalité, la fonctionnalité étant une connexion à une grille, une source, un drain, un émetteur ou un collecteur des dispositifs de commutation (3).

7. Module de puissance selon l'une quelconque des revendications précédentes,
dans lequel les connecteurs (8, 11, 20) des chemins auxiliaires (7, 10) correspondants sont connectés entre un contact du dispositif de commutation (3) respectif et un motif métallique (4, 14).

8. Module de puissance selon l'une quelconque des revendications 1 à 6,
dans lequel la portion de connexion (9, 12, 17, 18, 19) connecte entre eux des motifs métalliques (4) distincts, les motifs métalliques (4) distincts étant situés sur le même substrat (2) ou sur des substrats (2) différents.

9. Module de puissance selon l'une quelconque des revendications précédentes,
comprenant un dispositif de commutation côté bas et un dispositif de commutation côté haut formant un demi-pont, dans lequel la portion de connexion (9, 12, 17, 18, 19) est prévue dans des trajets auxiliaires (7, 10) correspondants du dispositif de commutation côté haut et du dispositif de commutation côté bas.

10. Module de puissance selon l'une quelconque des revendications précédentes,
dans lequel au moins un des dispositifs de commutation (3) comprend plusieurs chemins auxiliaires (7, 10), dans lequel au moins deux des chemins auxiliaires (7, 10) comprennent une portion de connexion (9, 12, 17, 18, 19) avec des connecteurs (8, 11, 20) électriquement connectés en parallèle, dans lequel le nombre des connecteurs (8, 11, 20) électriquement connectés en parallèle est différent dans les chemins auxiliaires (7, 10), ou dans lequel un des chemins auxiliaires (7, 10) comprend une portion de connexion (9, 12, 17, 18, 19) avec des connecteurs (8, 11, 20) électriquement connectés en parallèle et un autre des chemins auxiliaires (7, 10) ne comprend pas une portion de connexion (9, 12, 17, 18, 19) avec des connecteurs (8, 11, 20) électriquement connectés en parallèle.

11. Procédé de fabrication du module de puissance (1) selon la revendication 4,
dans lequel le nombre de connecteurs (8, 11, 20) dans chacune des portions de connexion (9, 12, 17, 18, 19) est choisi de telle sorte que les inductances de grille des chemins auxiliaires (7, 10) correspondants soient réglées pour différer de 10 % au plus d'une valeur moyenne des inductances des chemins auxiliaires (7, 10) correspondants, dans lequel lorsque dans un des trajets auxiliaires (7, 10) une réduction de la valeur d'inductance est requise, le nombre de connecteurs (8, 11, 20) électriquement connectés en parallèle dans ce trajet auxiliaire (7, 10) est augmenté.
